# EUROPÄISCHE PATENTANMELDUNG

(11) **EP 2 621 039 A1**
(43) Veröffentlichungstag der Anmeldung: **31.07.2013**
(21) Anmeldenummer: 13160441.5
(22) Anmeldetag: 21.03.2013
(51) Int. Cl.: H02B 1/56, B23K 9/32, H05K 7/20

(54) **Outdoorgehäuse mit Wechselrichter und Gebläse**

(30) Priorität: 24.01.2012 AT 762012
(71) Anmelder: Fronius International GmbH, 4643 Pettenbach (AT)
(72) Erfinder: Mitteregger, Mario, 4643 Pettenbach (AT); Hochholzer, Daniel, 4724 Neukirchen a. Walde (AT); Graf, Jürgen, 4600 Wels (AT); Brandstätter, Albin, 4611 Buchkirchen (AT)
(74) Vertreter: Ofner, Clemens

(57) **Zusammenfassung**

Es wird ein Outdoorgehäuse mit einer Reinigungsvorrichtung (14) angegeben, umfassend ein Gehäuse (15), eine durch das Gehäuse (15) geführte Stromzuführung (16), welche mit einem innerhalb des Gehäuses (15) angeordneten Wechselrichter (17) verbunden ist, und einen mit dem Wechselrichter (17) verbundenen und durch das Gehäuse (15) geführten Stromausgang (18). Das Gehäuse (15) umfasst weiterhin eine im Gehäuse (15) angeordnete Ansaugöffnung (19) und eine im Gehäuse (15) angeordnete Ausblasöffnung (20) sowie ein im Gehäuse (15) angeordnetes Gebläse (21), welches zur Erzeugung eines von der Ansaugöffnung (19) über den Wechselrichter (17) zur Ausblasöffnung (20) verlaufenden Luftstroms zur vorgesehen ist Schließlich ist im Verlauf des Luftstroms ein Fliehkraftabscheider (22) mit einem Schmutzauslass (29) und einem Kühlluftauslass (26) vorgesehen, welcher den von der Ansaugöffnung (19) gelieferten Luftstrom reinigt. Der Kühlluftauslass ist mit dem Wechselrichter (17) verbunden und wird mit dem gereinigten Luftstrom gekühlt. Alternativ oder zusätzlich ist das Gebläse (21) als Radialgebläse ausgebildet, wobei ein Spiralgehäuse (33) des Radialgebläses (21) einen Schmutzauslass (35) umfasst.

## Beschreibung

Die Erfindung betrifft ein Outdoorgehäuse beziehungsweise einen Schaltschrank mit einem Gehäuse, einer durch das Gehäuse geführten Stromzuführung, welche mit einem innerhalb des Gehäuses angeordneten Wechselrichter verbunden ist, sowie einen mit dem Wechselrichter verbundenen und durch das Gehäuse geführten Stromausgang. Des Weiteren umfasst der Schaltschrank eine im Gehäuse angeordnete Ansaugöffnung und eine im Gehäuse angeordnete Ausblasöffnung sowie ein im Gehäuse angeordnetes Gebläse, welches zur Erzeugung eines von der Ansaugöffnung über den Wechselrichter zur Ausblasöffnung verlaufenden Luftstroms zur Kühlung vorgesehen ist.

Schaltschränke der genannten Art sind grundsätzlich bekannt. Dabei besorgt der im Schaltschrank angeordnete Wechselrichter eine Stromumformung von Gleich- zu Wechselstrom oder umgekehrt. Um den Wechselrichter in einem günstigen Temperaturbereich zu halten, wird mit dem Gebläse Kühlluft über denselben geführt. Insbesondere kann das Gebläse abhängig von der Temperatur des Wechselrichters angesteuert beziehungsweise geregelt werden. Beispielsweise wird es aktiviert oder wird mit erhöhter Leistung betrieben, wenn die Temperatur des Wechselrichters einen Schwellwert überschreitet. Desgleichen wird das Gebläse deaktiviert oder mit geringerer Leistung betrieben, wenn die Temperatur einen (vorzugsweise anderen) Schwellwert unterschreitet. Selbstverständlich sind hier aller Arten von Regelungen vorstellbar, insbesondere Proportionalregelungen, Differentialregelungen, Integralregelungen sowie Kombinationen derselben. Beispielsweise werden solche Schaltschränke im Zusammenhang mit Batterieladegeräten, Solaranlagen und Schweißgeräten verwendet.

Damit der Wechselrichter beziehungsweise auch andere gekühlte Aggregate nicht durch die Kühlluft verschmutzt werden, wenn der Schaltschrank in rauer Umgebung aufgestellt wird, kann auch ein Filter im Strömungsverlauf der Kühlluft angeordnet werden. Problematisch ist dabei, dass dieser mit der Zeit verschmutzt und die Kühlleistung absinkt. Wird dies nicht rechtzeitig erkannt, so kann der Wechselrichter überhitzen und Schaden nehmen. Um dies zu vermeiden werden daher häufig spezielle Überwachungseinrichtungen eingesetzt, um einen verschmutzten Filter zu detektieren. Dennoch ist ein Filterwechsel insbesondere bei Schaltschränken zeitaufwändig und damit kostenintensiv, welche an entlegenen Orten aufgestellt werden. Eine andere Möglichkeit, eine frühzeitige Filterverschmutzung zu verhindern besteht auch darin, den Filterstoff nicht zu engmaschig zu wählen. Zwar führt dies zum gewünschten Effekt, allerdings auch dazu, dass sich feiner Staub, welcher den Filter passiert, in den Kühlrippen eines Wechselrichters absetzt. Dies verursacht dann von Zeit zu Zeit wiederum Wartungsaufwand. Unter Umständen ist dies erst recht sehr zeitaufwändig, da der Wechselrichter dazu gesäubert werden muss.

Die Aufgabe der Erfindung ist es nun, ein verbessertes Outdoorgehäuse/einen verbesserten Schaltschrank anzugeben. Insbesondere sollen Wartungsintervalle, welche durch Verschmutzungen in der Kühlung bedingt sind, verlängert respektive Wartungen überhaupt vermieden werden.

Die Aufgabe der Erfindung wird mit einem Outdoorgehäuse/Schaltschrank der eingangs genannten Art gelöst, bei dem:
- im Verlauf des Luftstroms ein Fliehkraftabscheider mit einem Schmutzauslass und einem Kühlluftauslass vorgesehen ist und/oder
- das Gebläse als Radialgebläse ausgebildet ist und ein Spiralgehäuse des Radialgebläses einen Schmutzauslass und einem Kühlluftauslass umfasst,
welcher/welches den von der Ansaugöffnung gelieferten Luftstrom reinigt und wobei der Kühlluftauslass mit dem Wechselrichter verbunden ist und diesen mit dem gereinigtem Luftstrom kühlt.

Auf diese Weise kann die Kühlluft gesäubert werden, ohne dass dazu zwingend ein Filter mit einem Filtermedium vonnöten wäre. Somit können Wartungsintervalle, welche durch Verschmutzungen in der Kühlung bedingt sind, verlängert respektive Wartungen überhaupt vermieden werden.

Unter einem "Outdoorgehäuse" ist im Rahmen der Erfindung ein Gehäuse zu verstehen, dass im Außenbereich respektive in einem Bereich mit beeinträchtigenden Umweltbdinungen aufgestellt werden kann. Ein solcher Bereich mit hohem Verschmutzungsgrad oder hoher Luftfeuchtigkeit kann auch im Inneren eines Gebäudes oder auch unter der Erde liegen. Ein Outdoorgehäuse hält somit zwar Umweltbedingungen stand, ist aber nicht zwangsläufig außerhalb eines Gebäudes aufgestellt.

Vorteilhafte Ausgestaltungen und Weiterbildungen der Erfindung ergeben sich aus den Unteransprüchen sowie aus der Beschreibung in Zusammenschau mit den Figuren.

Vorzugsweise umfasst das Outdoorgehäuse/der Schaltschrank einen im Strömungsverlauf des Luftstroms hinter dem Fliehkraftabscheider beziehungsweise Spiralgehäuse des Gebläses angeordneten Luftfilter. Dadurch kann die Kühlluft noch besser gereinigt werden, da mit Hilfe eines Filters Schmutzpartikel ausgesondert werden können, welche den Fliehkraftabscheider respektive das Spiralgehäuse passieren. Dennoch verschmutzt der Filter beziehungsweise das Filtermedium in einer solchen Anordnung nicht so rasch wie bei nach dem Stand der Technik bekannten Schaltschränken.

Vorzugsweise umfasst das Outdoorgehäuse/der Schaltschrank einen im Strömungsverlauf des Luftstroms hinter dem Fliehkraftabscheider des Gebläses angeordneten Labyrinthabscheider. Der Labyrinthabscheider bietet eine weitere Mögllichkeit, die Kühlluft zu säubern. Im Gegensatz zu einem herkömmlichen Filter ist dazu kein Filtermedium vonnöten. Der Labyrinthabscheider braucht daher in aller Regel nicht gewartet werden. Vorteilhaft ist auch, dass der Labyrinthabscheider schon bei niedrigen Strömungsgeschwindigkeiten arbeitet. Dadurch kann die Kühlluft auch bei schwankendem Volumensstrom effektiv gefiltert werden, bei niedrigen Strömungsgeschwindigkeiten vorwiegend durch den Labyrinthabscheider, bei höheren Strömungsgeschwindikeiten vorwiegend durch den Fliehkraftabscheider oder das Radialgebläse. Ein schwankender Volumensstrom kann beispielsweise dann entstehen, wenn die Temperatur des Wechselrichters geregelt ist und das Gebläse das Stellglied ist. Wird der Wechselrichter heißer, so wird dabei die Leistung des Gebläses und damit der Volumenstrom erhöht.

Günstig ist es, wenn der der Fliehkraftabscheider wenigstens eine Zyklone umfasst. Dies ist eine besonders einfache jedoch auch effektive Bauart eines Fliehkraftabscheiders. Ein Schaltschrank mit einem solchen Fliehkraftabscheider kann daher kostengünstig hergestellt werden. Vorteilhaft ist es, wenn der Schmutzauslass des Fliehkraftabscheiders beziehungsweise des Spiralgehäuses des Gebläses oder ein Schmutzauslass des Labyrinthabscheiders mit einem im Gehäuse angeordneten Schmutzauffangbehälter verbunden ist, insbesondere mit einem gemeinsamen Schmutzauffangbehälter. Auf diese Weise wird der ausgesonderte Schmutz gesammelt und kann bedarfsweise entsorgt werden. Je nach Größe des Schmutzauffangbehälters ergeben sich mehr oder weniger lange Wartungsintervalle.

Besonders vorteilhaft ist es, wenn der Schmutzauslass des Fliehkraftabscheiders beziehungsweise des Spiralgehäuses des Gebläses oder ein Schmutzauslass des Labyrinthabscheiders mit einem durch das Gehäuse nach außen geführten Ablauf verbunden ist. Bei dieser Variante wird der Schmutz überhaupt aus dem Schaltschrank hinausbefördert, sodass dieser weitgehen wartungsfrei ist.

Vorzugsweise umfasst das Outdoorgehäuse/der Schaltschrank eine Überwachungseinrichtung, welche dazu eingerichtet ist, einen verschmutzen Luftfilter und/oder einen vollen Schmutzauffangbehälter und/oder einen verstopften Ablauf zu detektieren. Dazu kann beispielsweise der Differenzdruck am Luftfilter, der Differenzdruck am Gebläse und/oder die Drehzahl des Gebläses gemessen werden. Zeigen die Parameter einen erhöhten Strömungswiderstand am Filter an, so wird beispielsweise ein Alarm ausgelöst. Die Überwachungseinrichtung kann alternativ oder zusätzlich auch dazu eingerichtet sein, einen vollen Schmutzauffangbehälter zu detektieren. Dazu kann beispielsweise der Füllstand in dem besagten Schmutzauffangbehälter gemessen werden. Übersteigt der Füllstand einen bestimmten Schwellwert wird wiederum Alarm ausgelöst. Zudem kann ein Füllstandssensor auch im Bereich eines Schmutzabführrohrs montiert sein, um eine Verstopfung desselben zu detektieren.

### Vorteilhaft ist es, wenn

- der Wechselrichter Bestandteil einer im Gehäuse angeordneten Schweißstromquelle und der Stromausgang mit einer Schweißpistole verbunden ist oder verbindbar ist oder
- der Wechselrichter Bestandteil eines im Gehäuse angeordneten Batterieladegeräts ist und der Stromausgang mit einem Akkumulator verbunden ist oder verbindbar ist oder
- der Wechselrichter Bestandteil einer im Gehäuse angeordneten Solaranlagen-Betriebselektrik ist und die Stromzuführung mit einem solaren Stromerzeuger und der Stromausgang mit einem zu versorgenden Stromnetz verbunden ist oder verbindbar ist.

Die vorgestellte Luftreinigung eignet insbesondere für Outdoorgehäuse/Schaltschränke, welche an Standorten aufgestellt sind, an denen mit erhöhter Luftverschmutzung zu rechnen ist. Der Vorteil der Erfindung tritt darüber hinaus dann besonders hervor, wenn der Schaltschrank an einem entlegenen Ort aufgestellt ist und die Wartung des Schaltschranks daher alleine schon wegen der Anreise zeit- und kostenintensiv ist.

Beispielsweise treffen diese Voraussetzungen für Schaltschränke für Anlagen zur regenerativen Energieerzeugung (z.B. Solaranlagen) zu, welche in der Wüste aufgestellt sind und durch Sand beeinträchtigt sind. Zu der genannten Betriebselektrik gehören beispielsweise Regler, welche die Photovoltaik-Module in einem optimalen Betriebspunkt (z.B. dem Maximum Power Point) halten, und/oder eine Steuerung zur Nachführung der Module gemäß einem aktuellen Sonnenstand.

Die erwähnten Voraussetzungen treffen aber auch für einen Schaltschrank zu, welcher ein Batterieladegerät beinhaltet und beispielsweise Teil einer Stromtankstelle für Elektrokraftfahrzeuge an einem exponierten Standort ist.

Schließlich eignet sich die vorgestellte Luftreinigung aber auch für Schaltschränke, die in der industriellen Umgebung eingesetzt werden, beispielsweise für einen Schaltschrank, welcher für ein Schweißgerät vorgesehen ist.

Zum besseren Verständnis der Erfindung wird diese anhand der nachfolgenden Figuren näher erläutert.
- Fig. 1: eine schematische Übersichtsdarstellung eines Wechselrichters einer Photovoltaikanlage;
- Fig. 2: ein Prinzipschaltbild eines Outdoorgehäuses/Schaltschranks mit Gebläse und einem dem Gebläse vorgeschalteten Fliehkraftabscheider;
- Fig. 3: eine Schrägansicht eines Outdoorgehäuses/Schaltschranks mit einem Fliehkraftabscheider;
- Fig. 4: die Funktionsweise einer Zyklone;
- Fig. 5: ein Beispiel für einen Labyrinthabscheider und
- Fig. 6: ein Radialgebläse mit einem Schmutzauslass im Spiralgehäuse.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereich beginnen mit einer unteren Grenze von 1 oder größer und enden bei einer oberen Grenze von 10 oder weniger, z.B. 1 bis 1,7, oder 3,2 bis 8,1 oder 5,5 bis 10.

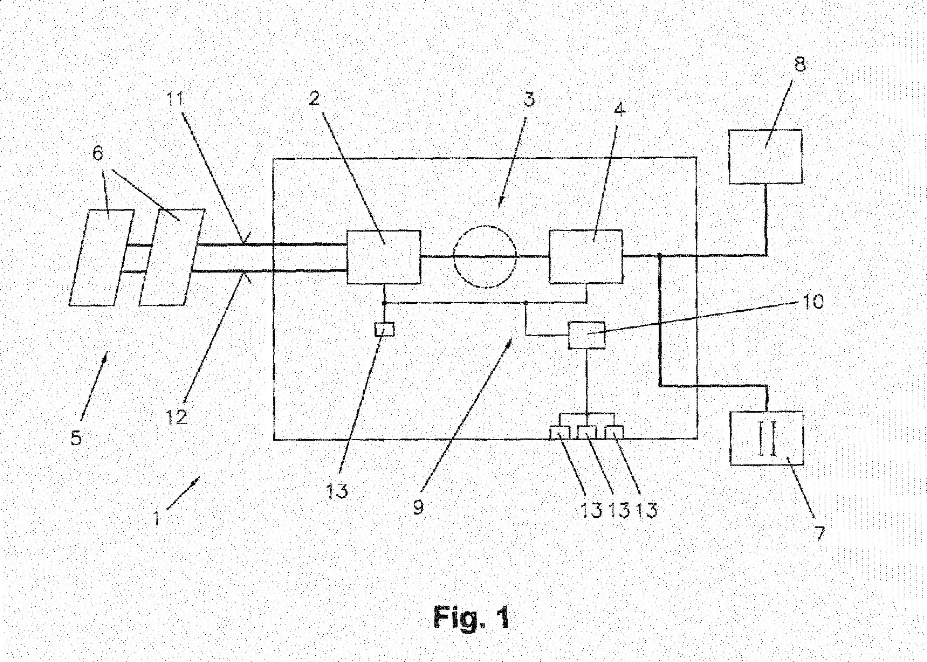

In Fig. 1 ist ein Aufbau eines bekannten Wechselrichters 1, im Detail eines HF-Wechselrichters, dargestellt. Da die einzelnen Komponenten bzw. Baugruppen und Funktionen von Wechselrichtern 1 bereits aus dem Stand der Technik bekannt sind, wird auf diese nachstehend nicht im Detail eingegangen.

Der Wechselrichter 1 weist zumindest einen Eingangs-DC-DC-Wandler 2, einen Zwischenkreis 3 und einen Ausgangs-DC-AC-Wandler 4 auf. Am Eingangs-DC-DC-Wandler 2 ist eine Energiequelle 5 bzw. ein Energieerzeuger angeschlossen, welche bevorzugt aus einem oder mehreren parallel und/oder seriell zueinander geschalteten Solarmodulen 6 gebildet werden. Der Wechselrichter 1 und die Solarmodule 6 werden auch als Photovoltaikanlage bzw. als PV- Anlage bezeichnet. Der Ausgang des Wechselrichters 1 bzw. des Ausgangs-DC-AC-Wandlers 4 kann mit einem Versorgungsnetz 7, wie ein öffentliches oder privates Wechselspannungsnetz oder ein Mehr-Phasennetz, und/oder mit zumindest einem elektrischen Verbraucher 8, welcher eine Last darstellt, verbunden sein. Beispielsweise wird ein Verbraucher 8 durch einen Motor, Kühlschrank, Funkgerät usw. gebildet. Ebenso kann der Verbraucher 8 auch eine Hausversorgung darstellen. Die einzelnen Komponenten des Wechselrichters 1, wie der Eingangs-DC-DC-Wandler 2 usw., können über einen Datenbus 9 mit einer Steuervorrichtung 10 verbunden sein.

Bevorzugt dient ein derartiger Wechselrichter 1 als so genannter netzgekoppelter Wechselrichter 1, dessen Energiemanagement daraufhin optimiert ist, möglichst viel Energie in das Versorgungsnetz 7 einzuspeisen. Wie aus dem Stand der Technik bekannt, werden die Verbraucher 8 über das Versorgungsnetz 7 versorgt. Selbstverständlich können auch mehrere parallel geschaltete Wechselrichter 1 eingesetzt werden. Dadurch kann mehr Energie zum Betrieb der Verbraucher 8 bereitgestellt werden.

Diese Energie wird von der Energiequelle 5 in Form einer Gleichspannung geliefert, welche über zwei Anschlussleitungen 11, 12 mit dem Wechselrichter 1 verbunden ist.

Die Steuervorrichtung 10 bzw. der Regler des Wechselrichters 1 ist beispielsweise durch einen Mikroprozessor, Mikrocontroller oder Rechner gebildet. Über die Steuervorrichtung 10 kann eine entsprechende Steuerung der einzelnen Komponenten des Wechselrichters 1 wie dem Eingangs-DC-DC-Wandler 2 oder dem Ausgangs-DC-AC-Wandler 4, insbesondere der darin angeordneten Schaltelemente, vorgenommen werden. In der Steuervorrichtung 10 sind hierzu die einzelnen Regel- bzw. Steuerabläufe durch entsprechende Software-Programme und/oder Daten bzw. Kennlinien gespeichert.

Des Weiteren sind mit der Steuervorrichtung 10 Bedienelemente 13 verbunden, durch welche der Benutzer beispielsweise den Wechselrichter 1 konfigurieren und/oder Betriebszustände oder Parameter anzeigen - beispielsweise mittels Leuchtdioden - und einstellen kann. Die Bedienelemente sind dabei beispielsweise über den Datenbus 9 oder direkt mit der Steuervorrichtung 10 verbunden. Derartige Bedienelemente 13 sind beispielsweise an einer Front des Wechselrichters 1 angeordnet, sodass eine Bedienung von außen möglich ist. Ebenso können die Bedienelemente 13 auch direkt an Baugruppen und/oder Modulen innerhalb des Wechselrichters 1 angeordnet sein.

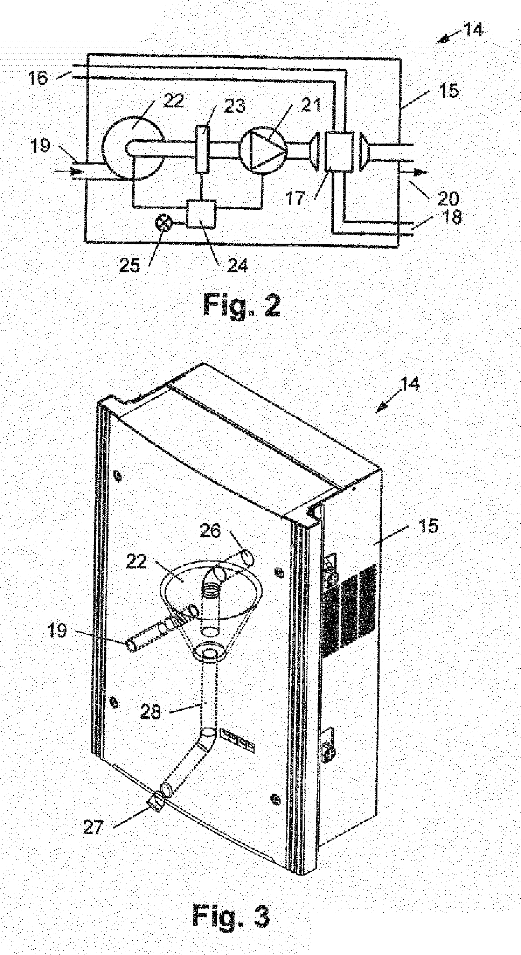

Fig. 2 zeigt ein Prinzipschaltbild eines Outdoorgehäuses/Schaltschranks 14 mit einem Gehäuse 15, einer durch das Gehäuse 2 geführten Stromzuführung 16, welche mit einem innerhalb des Gehäuses 15 angeordneten Wechselrichter 17 verbunden ist, und einen mit dem Wechselrichter 17 verbundenen und einen durch das Gehäuse 15 geführten Stromausgang 18. Weiterhin umfasst der Schaltschrank 14 eine im Gehäuse 15 angeordnete Ansaugöffnung 19 und eine im Gehäuse 15 angeordnete Ausblasöffnung 20 sowie ein im Gehäuse 15 angeordnetes Gebläse 21. Das Gebläse 21 ist zur Erzeugung eines von der Ansaugöffnung 19 über den Wechselrichter 17 zur Ausblasöffnung 20 verlaufenden Luftstroms, welcher durch einen Zuluftpfeil und einen Abluftpfeil visualisiert ist, vorgesehen. Schließlich ist in diesem Beispiel im Verlauf des Luftstroms ein Fliehkraftabscheider 22 mit einem Schmutzauslass vorgesehen.

Auf diese Weise wird der Wechselrichter 17 mit sauberer Kühlluft gekühlt, da angesaugte Schmutzpartikel über den Fliehkraftabscheider 22 ausgesondert werden. Die Kühlung ist somit weitgehend wartungsfrei, da die im Verlauf des Luftstroms angeordneten Komponenten, insbesondere der Wechselrichter 17, nicht so schnell verschmutzen und die Kühlwirkung somit über einen langen Zeitraum erhalten bleibt.

Der Luftstrom wird im Bereich des Wechselrichters 17 in diesem Beispiel offen, das heißt ohne Kanal, geführt. Auf diese Weise ist der Wechselrichter 17 besonders leicht zugänglich. Selbstverständlich kann der Luftstrom aber auch innerhalb eines Kanals über den Wechselrichter 17 geführt werden. Schließlich ist es auch möglich, einen Luftstrom durch das Gehäuse 15 des Schaltschranks 14 zu erzeugen, in dem die Ansaugöffnung 19 und die Ausblasöffnung 20 einfach einander gegenüber angeordnet werden und eine der beiden mit dem Gebläse 21 verbunden werden. Damit ergibt sich auch ohne spezielle Führung des Luftstroms durch Kanäle oder Rohre eine Querströmung durch den Schaltschrank 14, in deren Verlauf der Wechselrichter 17 angeordnet und damit gekühlt wird. Schließlich wird der Vollständigkeit halber auch angemerkt dass im Verlauf des Luftstroms auch andere zu kühlende Komponenten als der Wechselrichter 17 angeordnet sein können, zum Beispiel Motoren oder Mikroprozessoren.

Abschließend wird angemerkt, dass der Wechselrichter 17 nicht notwendigerweise direkt mit der Stromzuführung 16 und/oder dem Stromausgang 18 verbunden sein muss. Selbstverständlich können im Stromverlauf noch andere Baugruppen vorgesehen sein, beispielsweise Filterschaltungen, PFC-Schaltungen (Power Factor Correction), Filterkondensatoren und vieles mehr.

In dem in Fig. 2 gezeigten Beispiel ist im Strömungsverlauf des Luftstroms hinter dem Fliehkraftabscheider 22 ein optionaler Luftfilter 23 angeordnet, um Schmutzpartikel aus dem Luftstrom auszusondern, welche nicht durch den Fliehkraftabscheider 22 ausgeschieden werden. Die Kühlluft ist somit noch sauberer beziehungsweise kann die Kühlluft auch bei verleichsweise geringer Strömungsgeschwindigkeit effektiv gesäubert werden, wodurch der Schaltschrank insgesamt weniger laut ist.

In der Fig. 2 ist zudem eine optionale Überwachungseinrichtung 24 vorgesehen, welche dazu eingerichtet ist, einen verschmutzen Luftfilter 23 zu detektieren. Dazu kann beispielsweise der Differenzdruck am Luftfilter 23, der Differenzdruck am Gebläse 21 und/oder die Drehzahl des Gebläses 21 gemessen werden. Zeigen die Parameter einen erhöhten Strömungswiderstand am Filter 23 an, so wird beispielsweise eine Signallampe 25 aktiviert. Selbstverständlich ist auch eine Alarmierung über eine Fernmeldeeinrichtung möglich, was insbesondere dann von Vorteil ist, wenn der Schaltschrank 14 an abgelegener Stelle installiert ist.

Die Überwachungseinrichtung 24 kann alternativ oder zusätzlich auch dazu eingerichtet sein, einen vollen Schmutzauffangbehälter, welcher mit dem Fliehkraftabscheider 22 verbunden ist, zu detektieren. Dazu kann beispielsweise der Füllstand in dem besagten Schmutzauffangbehälter gemessen werden. Übersteigt der Füllstand einen bestimmten Schwellwert wird wiederum Alarm ausgelöst.

Der Vorteil des dargestellten Outdoorgehäuses/Schaltschranks 14 ist, dass dieser wegen dem Fliehkraftabscheider 22 lange Zeit wartungsfrei laufen kann, da dieser an sich nicht verschmutzt. Lediglich ein Schmutzauffangbehälter sollte von Zeit zu Zeit entleert werden. Selbst wenn ein Filter 23 (beispielsweise ein Filtervlies) vorgesehen ist, werden für den Schaltschrank 14 nur vergleichsweise lange Wartungsintervalle benötigt, da ein Großteil der Schmutzpartikel durch den Fliehkraftabscheider 22 ausgesondert werden und der Filter 23 daher nur vergleichsweise langsam verschmutzt.

Der Fliehkraftabscheider 22 kann wie in Fig. 3 dargestellt beispielweise als Zyklonabscheider (kurz "Zyklone") ausgebildet sein. Dabei wird Luft über eine Ansaugöffnung 19 eingesaugt, in der Zykone 22 in Rotation versetzt und über die Abluftöffnung 26 gesäubert weitergeleitet. Der ausgesonderte Schmutz fällt in einen Schmutzauslass der Zyklone 22 und kann in einen Schmutzauffangbehälter weitergeleitet oder wie in der Fig. 3 dargestellt über einen durch das Gehäuse nach außen geführten Ablauf 27 abgeführt werden. Wegen des Ablaufs 27 sind die Wartungsintervalle für diesen Schaltschrank 14 besonders lange, da kein Schmutzauffangbehälter entleert werden braucht.

Da prinzipiell auch hier die Möglichkeit besteht, dass der Ablauf 27 verlegt wird, beipielsweise durch Tiere oder ausgesonderten Schmutz, welcher sich im Bereich des Ablaufs 27 anhäuft, ist es auch bei dieser Variante vorteilhaft, einen Füllstandsdetektor im Verlauf des Schmutzabführrohrs 28 vorzusehen und mit einer Überwachungseinrichtung 24 zu verbinden.

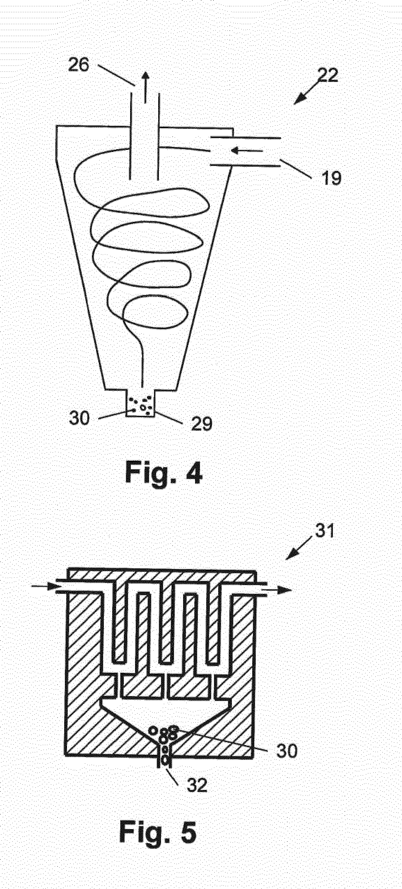

Fig. 4 verdeutlicht das an sich bekannte Wirkprinzip eines Zyklonabscheiders 22. Luft wird über die Ansaugöffnung 19 angesaugt, in der Zykone in Rotation versetzt und dann gesäubert über die Abluftöffnung 26 weitergeleitet. Ausgesonderter Schmutz 30 wird in diesem Beispiel in einem Schmutzauffangbehälter 29 gelagert.

Anstelle eines Filters 23 mit einem Filtermedium oder zusätzlich dazu kann auch ein Labyrinthabscheider 31 eingesetzt werden, so wie er beispielsweise in Fig. 5 dargestellt ist. Dabei wird angesaugte Luft über ein Labyrinth geleitet, beispielsweise über mänderförmig angelegte Kanäle und Schmutz 30 an den Biegungen ausgesondert. Dieser wird gesammelt und über ein Ablaufrohr 32 abgeleitet. Vorteilhaft ist auch dieser Abscheider 31 wegen eines fehlenden Filtermediums weitgehend wartungsfrei. Selbstverständlich zeigt die Fig. 5 nur eine von vielen möglichen Ausführungsformen eines Labyrinthabscheiders 31. Andere Bauformen können aber gleichwertig eingesetzt werden.

Insbesondere in Kombination mit einer Zyklone 22 ergeben sich besondere Vorteile, da diese größere Schmutzpartikel aussondern kann beziehungsweise erst bei relativ hohen Strömungsgeschwindigkeiten wirksam arbeitet, wohingegen der Labyrinthabscheider 31 schon bei niedrigen Strömungsgeschwindigkeiten arbeitet und auch feinerere Schmutzpartikel aussondert. Dadurch kann die Kühlluft auch bei schwankendem Volumensstrom effektiv gefiltert werden, bei niedrigen Strömungsgeschwindigkeiten vorwiegend durch den Labyrinthabscheider 31, bei höheren Strömungsgeschwindikeiten vorwiegend durch die Zyklone 22. Ein schwankender Volumensstrom kann beispielsweise dann entstehen, wenn die Temperatur des Wechselrichters 17 geregelt ist und das Gebläse 21 das Stellglied ist. Wird der Wechselrichter 17 heißer, so wird dabei die Leistung des Gebläses 21 und damit der Volumenstrom erhöht.

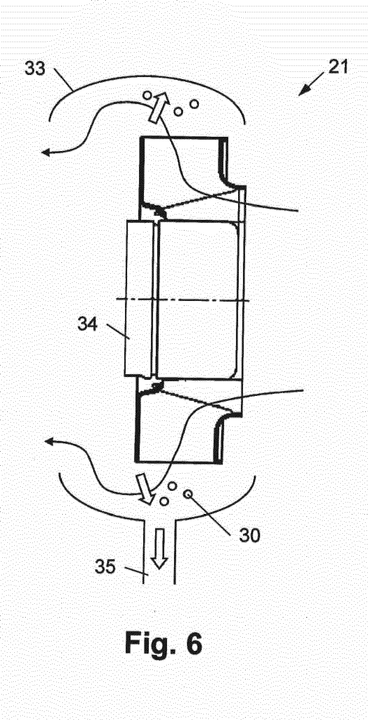

Fig. 6 zeigt schließlich eine weitere Möglichkeit zur Aussonderung von Schmutz aus einem Luftstrom. Zusätzlich zu einem Fliehkraftabscheider 22 oder statt diesem kann das Gebläse 21 als Radialgebläse ausgebildet sein, dessen Spiralgehäuse 33 einen Schmutzauslass umfasst. In an sich bekannter Weise wird ein Luftstrom bei einem Radialgebläse 21 durch ein Laufrad 34 im Spiralgehäuse in Rotation versetzt. Dieser Effekt kann ebenfalls dazu ausgenützt werden, die transportierte Luft zu reinigen, in dem die nach außen gedrückten Schmutzpartikel 30 durch einen Schmutzauslaus 35 abgeführt werden. Wird ein solches Gebläse 21 anstelle eines Fliehkraftabscheiders 22 vorgesehen, so ist der Aufbau des Schaltschranks 14 besonders einfach.

Die vorgestellte Luftreinigung eignet insbesondere für Outdoorgehäuse/Schaltschränke 14, welche an Standorten aufgestellt sind, an denen mit erhöhter Luftverschmutzung zu rechnen ist. Der Vorteil der Erfindung tritt darüber hinaus dann besonders hervor, wenn der Schaltschrank 14 an einem entlegenen Ort aufgestellt sind und die Wartung des Schaltschranks 14 daher alleine schon wegen der Anreise zeit- und kostenintensiv ist.

Beispielsweise treffen diese Voraussetzungen für Schaltschränke 14 für Anlagen zur regenerativen Energieerzeugung (z.B. Solaranlagen) zu, welche in der Wüste aufgestellt sind. Eine solche Solaranlage umfasst in aller Regel einen Stromerzeuger, beispielsweise eine Vielzahl an Photovoltaik-Modulen, und einen Schaltschrank 14, welcher die Solaranlagen-Betriebselektrik beinhaltet (siehe dazu auch Fig. 1). Zu dieser Betriebselektrik gehören beispielsweise Regler, welche die Photovoltaik-Module in einem optimalen Betriebspunkt (z.B. dem Maximum Power Point) halten, und eine Steuerung zur Nachführung der Module gemäß einem aktuellen Sonnenstand und insbesondere auch einen Wechselrichter 17. Die Stromzuführung 16 ist dabei mit den Photovoltaik-Modulen und der Stromausgang 18 mit einem zu versorgenden Stromnetz verbunden, sodass die Gleichspannung der Photovoltaik-Module in eine für das Stromnetz (in aller Regel erforderliche) Wechselspannung umwandelt.

Die erwähnten Voraussetzungen treffen aber auch für einen Schaltschrank 14 zu, welcher ein Batterieladegerät beinhaltet und beispielsweise Teil einer Stromtankstelle für Elektrokraftfahrzeuge an einem exponierten Standort ist. Dabei wird die Stromzuführung 16 mit einem Stromnetz und der Stromausgang 18 mit einem zu ladenden Akkumulator verbunden. Der Wechselrichter 17 wandelt die Wechselspannung des Netzes dabei in eine für den Ladevorgang benötigte Gleichspannung um.

Schließlich eignet sich die vorgestellte Luftreinigung aber auch für Schaltschränke 14, die in der industriellen Umgebung eingesetzt werden, beispielsweise für einen Schaltschrank 14, welcher für ein Schweißgerät vorgesehen ist. Dabei ist der Wechselrichter 17 Bestandteil einer im Gehäuse 15 angeordneten Schweißstromquelle, wobei der Stromausgang 18 mit einer Schweißpistole verbunden ist oder verbindbar ist.

Die Ausführungsbeispiele zeigen mögliche Ausführungsvarianten eines erfindungsgemäßen Schaltschranks 14, wobei an dieser Stelle bemerkt sei, dass die Erfindung nicht auf die speziell dargestellten Ausführungsvarianten desselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mit umfasst.

Insbesondere wird festgehalten, dass ein Schaltschrank 14 in der Realität auch mehr Bestandteile als dargestellt umfassen kann, typischerweise elektronische Steuerungen und/oder Regelungen, Schütze, Baueinheiten zur Stromversorgung, Bedienelemente sowie Anzeigen und dergleichen.

Man kann also sagen, dass zur Reinigung der Kühlluft ein Fliehkraftabscheider 22 im Gehäuse 15 angeordnet ist und desen Luftauslass im Inneren des Gehäuses 15 zur Kühlung der Komponenten, insbesondere des Wechselrichters 17, endet, wobei der Lufteinlass vom Gehäuse 15 nach außen zum Ansaugen von Luft führt, und dass ein Schmutzauslass 29 des Fliehkraftabscheiders 22 in einem Behälter endet oder aus dem Inneren des Gehäuses nach Außen geführt ist.

Der Ordnung halber sei abschließend darauf hingewiesen, dass zum besseren Verständnis des Aufbaus des Schaltschranks 14 dieser bzw. deren Bestandteile teilweise unmaßstäblich und/oder vergrößert und/oder verkleinert dargestellt wurden.

Die den eigenständigen erfinderischen Lösungen zugrundeliegende Aufgabe kann der Beschreibung entnommen werden.

**Bezugszeichenaufstellung**

| | |
|---|---|
| 1 | Wechselrichter |
| 2 | Eingangs-DC-DC |
| 3 | Zwischenkreis |
| 4 | Ausgangs-DC-DC |
| 5 | Energiequelle |
| | |
| 6 | Solarmodulen |
| 7 | Netz |
| 8 | Verbraucher |
| 9 | Datenbus |
| 10 | Steuervorrichtung |
| | |
| 11 | Anschlussleitung |
| 12 | Anschlussleitung |
| 13 | Bedienelement |
| 14 | Schaltschrank |
| 15 | Gehäuse |
| | |
| 16 | Stromzuführung |
| 17 | Wechselrichter |
| 18 | Stromausgang |
| 19 | Ansaugöffnung |
| 20 | Ausblasöffnung |
| | |
| 21 | Gebläse |
| 22 | Fliehkraftabscheider |
| 23 | Filter |
| 24 | Überwachungseinrichtung |
| 25 | Signallampe |
| | |
| 26 | Abluftöffnung |
| 27 | Ablauf |
| 28 | Schmutzabführrohr |
| 29 | Schmutzauffangbehälter |
| 30 | Schmutzpartikel |
| | |
| 31 | Labyrinthabscheider |
| 32 | Ablaufrohr |
| 33 | Spiralgehäuse |
| 34 | Laufrad |
| 35 | Schmutzauslass |

## Patentansprüche

1. Outdoorgehäuse mit einer Reinigungsvorrichtung (14), umfassend ein Gehäuse (15), eine durch das Gehäuse (15) geführte Stromzuführung (16), welche mit einem innerhalb des Gehäuses (15) angeordneten Wechselrichter (17) verbunden ist, einen mit dem Wechselrichter (17) verbundenen und durch das Gehäuse (15) geführten Stromausgang (18), eine im Gehäuse (15) angeordnete Ansaugöffnung (19) und eine im Gehäuse (15) angeordnete Ausblasöffnung (20) sowie ein im Gehäuse (15) angeordnetes Gebläse (21), welches zur Erzeugung eines von der Ansaugöffnung (19) über den Wechselrichter (17) zur Ausblasöffnung (20) verlaufenden Luftstroms zur Kühlung vorgesehen ist,
**dadurch gekennzeichnet, dass**
- im Verlauf des Luftstroms ein Fliehkraftabscheider (22) mit einem Schmutzauslass (29) und einem Kühlluftauslass (26) und/oder ein im Verlauf des Luftstroms angeordnetes Spiralgehäuse (33) mit Radialgebläse (21) mit einem Schmutzauslass (29) und einem Kühlluftauslass (26) vorgesehen ist, welcher/welches den von der Ansaugöffnung (19) gelieferten Luftstrom reinigt, und dass der Kühlluftauslass mit dem Wechselrichter (17) verbunden ist und diesen mit dem gereinigtem Luftstrom kühlt.

2. Outdoorgehäuse (14) nach Anspruch 1, **gekennzeichnet durch** einen im Strömungsverlauf des Luftstroms hinter dem Fliehkraftabscheider (22) beziehungsweise Spiralgehäuse (33) des Gebläses (21) angeordneten Luftfilter (23).

3. Outdoorgehäuse (14) nach Anspruch 1 oder 2, **gekennzeichnet durch** einen im Strömungsverlauf des Luftstroms hinter dem Fliehkraftabscheider (22 beziehungsweise Spiralgehäuse (33) des Gebläses(21) angeordneten Labyrinthabscheider (31).

4. Outdoorgehäuse (14) nach einem der Ansprüche 1 bis 3, **dadurch gekennzeichnet, dass** der Fliehkraftabscheider (22) wenigstens eine Zyklone umfasst.

5. Outdoorgehäuse (14) nach einem der Ansprüche 1 bis 4, **dadurch gekennzeichnet, dass** der Schmutzauslass des Fliehkraftabscheiders (22) beziehungsweise des Spiralgehäuses (33) des Gebläses (21) und/oder ein Schmutzauslass (32) des Labyrinthabscheiders (31) mit einem im Gehäuse (15) angeordneten Schmutzauffangbehälter (29) verbunden ist.

6. Outdoorgehäuse (14) nach einem der Ansprüche 1 bis 4, **dadurch gekennzeichnet, dass** der Schmutzauslass des Fliehkraftabscheiders (22) beziehungsweise des Spiralgehäuses (33) des Gebläses (21) und/oder ein Schmutzauslass (32) des Labyrinthabscheiders (31) mit einem durch das Gehäuse (15) nach außen geführten Ablauf (27) verbunden ist.

7. Outdoorgehäuse (14) nach einem der Ansprüche 2 bis 6, **gekennzeichnet durch** eine Überwachungseinrichtung (24), welche dazu eingerichtet ist, einen verschmutzen Luftfilter (23) und/oder einen vollen Schmutzauffangbehälter (29) und/oder einen verstopften Ablauf (27) zu detektieren.

8. Outdoorgehäuse (14) nach einem der Ansprüche 1 bis 7, **dadurch gekennzeichnet, dass** der Wechselrichter (17) Bestandteil einer im Gehäuse (15) angeordneten Schweißstromquelle und der Stromausgang (18) mit einer Schweißpistole verbunden ist oder verbindbar ist.

9. Outdoorgehäuse (14) nach einem der Ansprüche 1 bis 7, **dadurch gekennzeichnet, dass** der Wechselrichter (17) Bestandteil eines im Gehäuse (15) angeordneten Batterieladegeräts ist und der Stromausgang (18) mit einem Akkumulator verbunden ist oder verbindbar ist.

10. Outdoorgehäuse (14) nach einem der Ansprüche 1 bis 7, **dadurch gekennzeichnet, dass** der Wechselrichter (17) Bestandteil einer im Gehäuse (15) angeordneten Solaranlagen-Betriebselektrik ist und die Stromzuführung (16) mit einem solaren Stromerzeuger und der Stromausgang (18) mit einem zu versorgenden Stromnetz verbunden ist oder verbindbar ist.
